# FASCICULE DE BREVET EUROPEEN

(11) **EP 2 132 770 B1**
(45) Date de publication et mention de la délivrance du brevet: **12.10.2011**
(21) Numéro de dépôt: 08735767.9
(22) Date de dépôt: 03.04.2008
(51) Int. Cl.: H01L 21/033, H01L 21/027

(54) **PROCEDE DE REALISATION DE DEPOTS LOCALISES**
VERFAHREN ZUM AUFTRAGEN LOKALISIERTER BESCHICHTUNGEN
METHOD OF DEPOSITING LOCALIZED COATINGS

(30) Priorité: 03.04.2007 FR 0754249
(43) Date de publication de la demande: 16.12.2009
(73) Titulaire: Commissariat à l'Énergie Atomique et aux Énergies Alternatives, 75015 Paris (FR)
(72) Inventeur: REMIAT, Bruno, F-38000 Grenoble (FR); VANDROUX, Laurent, F-38570 Le Cheylas (FR); SOUCHE, Florent, F-38380 Saint Laurent du Pont (FR)
(74) Mandataire: Ilgart, Jean-Christophe
(86) Numéro de dépôt international: PCT/EP2008/054022
(87) Numéro de publication internationale: WO 2008/125511

(56) Documents cités:
- GB-A- 2 059 679
- US-A- 4 614 564
- US-A- 5 554 488
- US-A1- 2002 009 881

## Description

### DOMAINE TECHNIQUE ET ART ANTÉRIEUR

L'invention concerne le domaine des techniques de dépôt, en particulier par PECVD, évaporation ou pulvérisation cathodique. Elle permet de localiser un dépôt effectué par une de ces techniques.

L'invention s'applique notamment à la réalisation de cellules photovoltaïques, en particulier à la réalisation d'électrodes, de type n ou de type p.

Plus généralement, elle convient à la formation de motifs ayant, par exemple, une largeur de l'ordre du millimètre, séparés entre eux par une largeur de l'ordre du millimètre, ou moins.

Les techniques couramment utilisées en microélectronique, ou dans le domaine des semiconducteurs, comme la photolithographie, sont inutilisables pour réaliser des dépôts localisés, de manière simple, à des coûts abordables. En effet, ces techniques nécessitent de réaliser un dépôt continu, ou pleine plaque, puis d'éliminer, par gravure, les zones inutiles. Ces techniques sont lentes et onéreuses.

Les techniques permettant de réaliser des dépôts localisés, autres que celles utilisées en microélectronique, sont, essentiellement :
- les techniques de dépôts électrolytiques, qui sont trop coûteuses,
- les techniques mettant en oeuvre un masquage mécanique : mais un masque métallique peut perturber un plasma utilisé lors du dépôt, tandis qu'un masque en un autre matériau, par exemple en polymère, ne présente pas le niveau de stabilité requis,
- les techniques par impression : elles conviennent pour des émulsions, mais pas pour d'autres matériaux. La technique de formation de deux couches de masques sur un substrat et de gravure d'une cavité dans ces deux couches est connue du document US-A-4614 564.

Il se pose donc le problème de réaliser des dépôts localisés, de manière plus simple et moins coûteuse que les techniques connues.

### EXPOSÉ DE L'INVENTION

Selon l'invention on réalise un masque, dit de dépôt, dans un ensemble de n couches, n étant de préférence égal à 1, 2 ou 3, reposant sur un substrat et définissant des ouvertures ou des cavités, sur ce substrat, dans ou sur lesquelles un dépôt localisé d'un matériau doit être effectué.

À cette fin, les cavités ont un profil tel que, lors de l'opération de dépôt, des parties de ces cavités ne sont pas recouvertes du matériau à déposer, formant ainsi des discontinuités, et une élimination du masque est possible à partir de ces zones non recouvertes ou de ces discontinuités.

La formation de ces zones non recouvertes ou de ces discontinuités permet en effet d'éliminer le masque aisément, par attaque chimique utilisant les discontinuités comme chemin privilégié.

Le masque de dépôt peut être par exemple réalisé à l'aide d'un masque en résine ou en pâte polymère. Ce dernier est formé par exemple par sérigraphie. Il permet de définir dans l'empilement de n couches des zones à graver pour former les cavités par lesquelles on pourra accéder au substrat.

Grâce au masque de dépôt, on va pouvoir ensuite localiser un dépôt d'un matériau, qui effectué par une technique telle que, par exemple, PECVD, évaporation ou pulvérisation cathodique.

L'invention a donc notamment pour objet un procédé de réalisation d'un dépôt non continu d'un premier matériau sur un substrat, comportant :
a) la formation d'un masque sur ce substrat, par formation d'au moins deux couches de masque, une couche supérieure et une couche inférieure, la plus proche du substrat, et gravure d'au moins une cavité dans ces couches, cette cavité ayant un profil tel que d'un dépôt, réalisé sur le substrat, à travers les cavités du masque, présente au moins une discontinuité sur ledit profil de la cavité,
b) le dépôt du premier matériau en silicium amorphe sur le substrat, à travers les cavités du masque, ce dépôt comportant au moins une discontinuité sur le profil de ladite cavité, puis l'oxydation du silicium amorphe,
c) l'élimination du masque.

La formation des cavités peut comporter un dépôt localisé préalable, sur lesdites deux couches de masque, d'une couche d'une pâte polymère ou de résine, dans des zones de gravure desdites deux couches de masque. La couche de polymère ou de résine est éliminée, ou pas, avant l'étape b). L'épaisseur du dépôt de pâte polymère ou de résine est par exemple compris entre 300 nm et 10 µm.

La gravure au moins de la couche la plus proche du substrat est de préférence une gravure non anisotrope, par exemple une gravure isotrope.

Les deux couches présentent de préférence des vitesses de gravure différentes l'une de l'autre. Par exemple, la couche supérieure est plus résistante à une chimie de gravure (sèche ou humide) que la couche inférieure. La couche supérieure peut aussi ensuite être gravée par une chimie de gravure différente de celle utilisée pour graver ensuite la couche inférieure du bicouche. Ces deux couches ont par exemple une épaisseur comprise entre 100 nm et 2000 nm.

Le premier matériau, à déposer sur le substrat, est du silicium amorphe, ce dernier est oxydé en surface après l'étape b) de dépôt.

La gravure de l'étape a) permet de préférence d'obtenir des flancs arrondis au moins dans la couche inférieure. De préférence encore, elle permet d'obtenir une gravure de la couche supérieure de manière à former un surplomb au-dessus de la zone gravée dans la couche inférieure. Ce surplomb a par exemple une longueur au moins égale à l'épaisseur de la couche inférieure.

Quant à l'étape c), elle peut être réalisée par gravure chimique des couches formant masque, par les zones de premier matériau formant discontinuités.

### BRÈVE DESCRIPTION DES DESSINS

- Les figures 1A et 1B représentent des étapes d'un mode de réalisation d'un procédé selon l'invention, avec un masque à deux couches,
- les figures 2 à 8 représentent des étapes d'un mode de réalisation d'un procédé selon l'invention,
- la figure 9 représente un mode de réalisation d'un procédé selon l'invention, avec un masque à trois couches,
- la figure 10 représente des dépôts résiduels latéraux après élimination d'un masque.

### EXPOSÉ DÉTAILLÉ DE MODES DE RÉALISATION PARTICULIERS

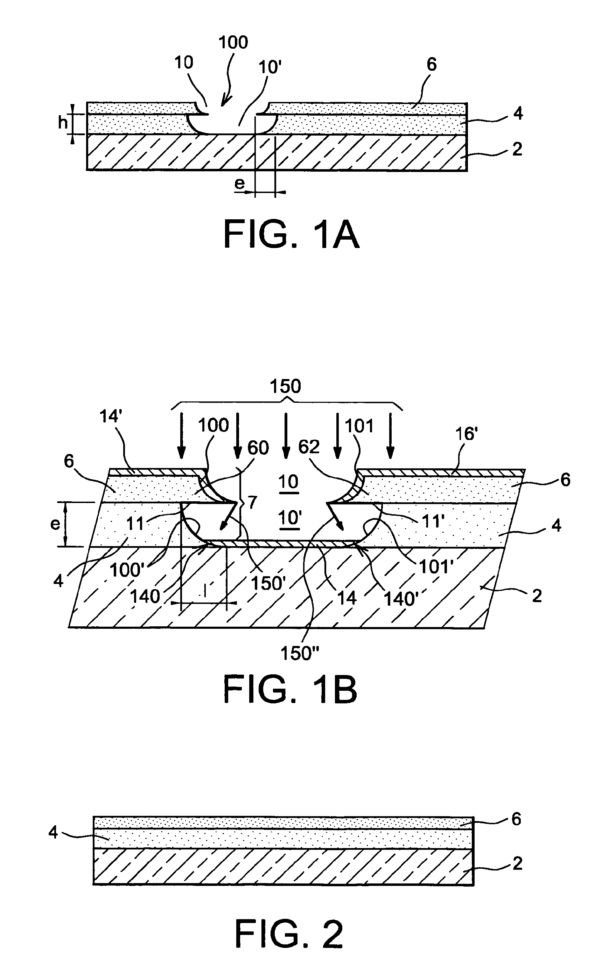

Comme illustré sur la figure 1A, l'invention permet de réaliser un masque de dépôt, constitué sur cette figure d'un ensemble de deux couches 4,6 superposées, dit bicouche. Ce masque présente des cavités 100 qui permettent de définir les zones, sur le substrat 2, sur lesquelles un dépôt pourra ensuite être réalisé. Une seule cavité est ici représentée, mais un nombre quelconque (deux ou plus) pourrait être prévu.

La figure 1B représente une cavité 100 agrandie. Elle est réalisée dans le bicouche et présente un profil latéral 7 tel que, lors d'un dépôt 150 du matériau à déposer, des portions 11, 11' de ce profil resteront vierges de ce dépôt.

Ainsi, on peut voir sur la figure 1B qu'un dépôt 14, 14', 16' est effectué au fond d'une cavité 100, ainsi que sur la face supérieure de la couche 6 (ce dépôt est référencé 14',16'), tandis que le dépôt n'atteint pas les zones 11, 11', formées par une avancée ou un surplomb 60, 62 de la couche 6, et délimitant une cavité 10 formée dans cette couche 6, au-dessus de la cavité 10' gravée dans la couche 4.

Chacune des zones 11, 11' inférieure des surplombs ou des avancées de la couche 6 a une extension latérale ou une longueur 1. Il est possible de déterminer, par des tests simples, notamment en fonction de l'épaisseur de matériau à déposer localement, la longueur 1 permettant d'obtenir un dépôt discontinu (c'est -à- dire une absence de dépôt au niveau d'une partie au moins des zones 11, 11').

Dans l'exemple représenté sur ces figures, on a gravé successivement les deux couches 6 puis 4, pour obtenir une cavité 10, 10' dans chaque couche. Une gravure non anisotrope permet de réaliser des cavités 10, 10' à flancs arrondis 100, 101, 100', 101' et un surplomb 60, 62 de la couche supérieure 6 au-dessus de la cavité 10' formée dans la couche 4.

Les cavités 100 ont un effet de « focalisation » de la matière lors de son dépôt 150. Cependant, des effets dus aux bords de ces ouvertures peuvent se produire. Ainsi les références 150', 150" désignent, sur la figure 1B, des flux de matière à déposer qui, du fait des surplombs 60, 62, vont être dirigés latéralement pour former les zones latérales 140, 140' du dépôt 14 au fond de la cavité 100. Ces zones latérales n'atteignent pas les faces inférieures 11, 11' des surplombs 60, 62, faces inférieures qui sont tournées vers la cavité 10'.

D'autres étapes d'un mode de réalisation de l'invention vont être décrites en liaison avec les figures 2 à 8.

Dans une première étape (figure 2), on procède sur un substrat 2 (ce dernier est par exemple en matériau semi-conducteur (notamment en silicium pour les applications photovoltaïques), ou en verre, ou en inox, ou tout autre matériau qui sera compatible avec les traitements chimiques ultérieurs) à un dépôt d'un empilement 4, 6 par CVD (PECVD ou CVD thermique ou SACVD (Sub-Atmospheric Chemical Vapour Deposition), cette dernière étant une technique de dépôt chimique en phase vapeur à une pression proche de la pression atmosphérique) ou par technique « spin » (dépôt « à la tournette »); on peut aussi utiliser des techniques telles que laminage ou par « spray ».

La couche 4 de l'empilement la plus proche du substrat 2, est destinée à être gravée soit sélectivement par rapport à la couche 6 de l'empilement (c'est-à-dire avec une technique de gravure qui n'affecte que la couche 4 et pas, ou très peu, la couche 6), soit avec une vitesse de gravure beaucoup plus importante que la couche 6, et ce afin d'obtenir les surplombs 60, 62.

Ainsi, on peut par exemple réaliser, en particulier en vue d'une attaque ultérieure avec une solution HF d'environ 5 à 10 % :
- une couche 6 de nitrure de silicium SiN sur une couche 4 d'oxyde de silicium,
- ou une couche 6 d'oxyde de silicium SiOₓ sur une couche 4 également en oxyde de silicium SiO_{y} (avec y<x≤2),
- ou une couche 6 d'oxyde de silicium sur une couche 4 de FSG ; le FSG est un oxyde de silicium contenant du fluor (jusqu'à plusieurs % de F). Il peut être déposé par dépôt chimique en phase vapeur (CVD) ou par centrifugation. Le FSG est plus sensible à une attaque HF que l'oxyde de silicium : il se grave donc plus rapidement,
- ou une couche 6 de nitrure de silicium SiN sur une couche 4 de FSG,
- ou une couche 6 de nitrure de silicium SiN sur une couche 4 de SOG ; SOG est l'abréviation de « spin-on glass », il s'agit d'oxyde de silicium déposé par centrifugation (dépôt à la tournette),
- ou une couche 6 de SOG (SOG1) sur une couche 4 de SOG (SOG2); SOG1 et SOG2 désignent deux matériaux SOG différents déposés par centrifugation : ils ont des compositions différentes et/ou des densités différentes et/ou des températures différentes de recuits. Les vitesses d'attaque par HF de ces deux matériaux sont donc différentes l'une de l'autre,
- ou une couche 6 de matériau diélectrique, organique (par exemple : BCB) sur une couche 4 d'oxyde de silicium..etc.

Ainsi, la couche supérieure 6 est choisie de façon à être plus résistante à une chimie de gravure que la couche inférieure 4 (ce qui signifie que la vitesse de gravure du matériau de la couche 6 est inférieure à la vitesse de gravure du matériau de la couche 4). Il peut même y avoir une sélectivité de gravure totale entre première et deuxième couche : une chimie de gravure différente de celle utilisée pour la couche 6 est alors utilisée pour graver la sous-couche 4 et lui transférer le motif.

On définit la sélectivité par le rapport entre les vitesses de gravure entre la couche supérieure 6 et celle de la couche inférieure 4.

Cette sélectivité existe notamment pour les couples SiN/SiO_{X}, SiN/FSG et SiOₓ/FSG (dans ces couples, le premier matériau mentionné est le matériau de la couche 6, le deuxième est le matériau de la couche 4), par rapport à une attaque au HF.

Pour le bicouche SiOₓ/SiOy, (y<x≤2) on peut adapter les paramètres de dépôt PECVD afin de diminuer la résistance au HF de la couche inférieure 4, ou de la partie inférieure de la couche unique (une couche de plus forte densité étant plus résistante à la gravure HF).

On peut aussi utiliser une sous-couche 4 de type a-Ge qui est attaquée sélectivement par une solution contenant du H₂O₂. La couche 6 est alors par exemple en dioxyde de silicium, attaqué sélectivement par du HF.

L'épaisseur du bicouche 4, 6 peut être par exemple comprise entre 100 nm et 2000 nm. Cette épaisseur permet de garantir ou d'assurer un rendement correct du procédé de dépôt localisé. Cette épaisseur est de préférence à adapter en fonction de l'épaisseur de la couche 14 à localiser par la suite.

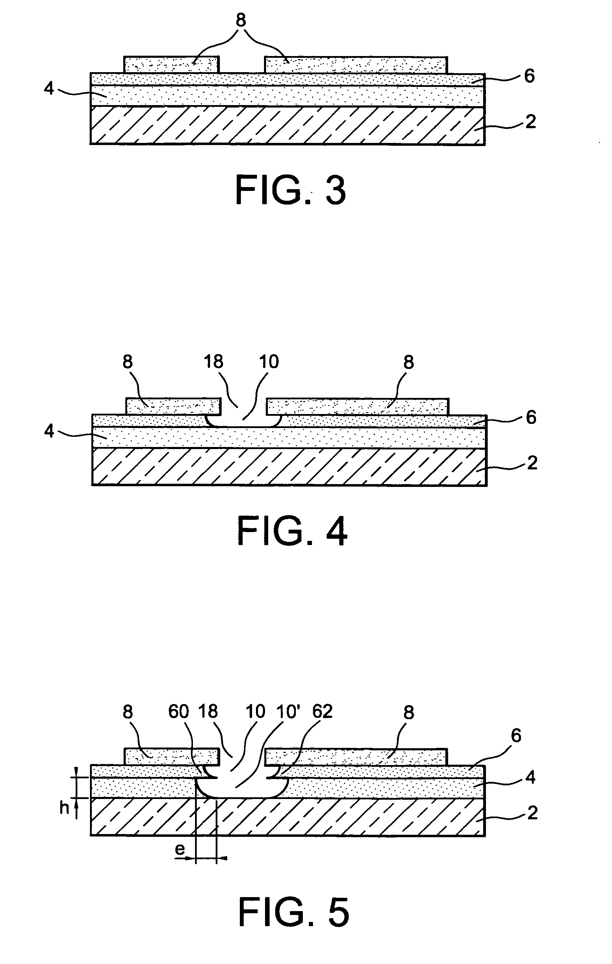

On procède ensuite (figure 3) à un dépôt d'une pâte polymère ou de résine 8 par sérigraphie et recuit éventuel. On peut prendre par exemple une pâte à base de polymère résistante à l'acide ou une pâte HF ou une pâte à base de polymère ou d'oxyde, tel du verre d'oxyde. Toutes ces pâtes sont des pâtes commerciales. On peut par exemple utiliser une pâte ayant la caractéristique de résister, après recuit, aux attaques des acides et de se dissoudre dans les bases. Il existe d'autres pâtes possédant des caractéristiques variables. On peut aussi utiliser des résines (du type proche de celui des résines de lithographie). Plus généralement, on pourra utiliser tout matériau qu'on peut déposer localement et qui résiste à la chimie utilisée ultérieurement, par exemple un diélectrique organique tel que le BCB.

Les épaisseurs du dépôt de pâte ou de résine 8 peuvent aller de quelques centaines de nm, par exemple 300 nm ou 500 nm, à plusieurs microns, par exemple 5 µm ou 10 µm. Au cours d'essais réalisés, l'épaisseur de pâte polymère déposée était comprise entre environ 5 µm et 10 µm mais des épaisseurs plus fines sont envisageables.

Le dépôt de pâte ou de résine 8 par sérigraphie laisse des ouvertures 18 qui permettent d'accéder à la couche supérieure du bicouche 4, 6.

Une gravure du bicouche 4, 6 est ensuite réalisée (figure 4) à partir des zones 18 définies par la sérigraphie: la différence de vitesse de gravure entre les deux couches 4, 6 permet d'obtenir le motif de surplomb souhaité, par exemple celui représenté en figure 5 (et de manière plus détaillée en figure 1B), à flancs « arrondis », dont la concavité est tournée vers les ouvertures 18. Pour la gravure du bicouche, on utilise une chimie unique ou deux chimies différentes selon l'empilement choisi.

Dans le cas de la gravure HF, une solution diluée à 5 % peut-être utilisée. On optimise cette gravure pour chaque empilement et en fonction de la sélectivité de gravure : on peut par exemple diminuer le temps d'attaque (plus le HF est concentré, plus le temps d'attaque est court) tout en évitant de dégrader les sous-couches (dans le cas d'une solution plus concentrée en HF -de l'ordre de 30 % à 49 %- des observations ont permis de mettre en évidence la formation de trous dans certaines sous-couches, par exemple a-Si:H).

Avantageusement, dans le cas d'une gravure de type humide (isotrope), des flancs arrondis (comme illustré sur les figures 4 et suivantes) sont obtenus dans les couches 4, 6 de gravure, la gravure en profondeur s'accompagnant d'une gravure latérale dont la concavité est tournée vers les ouvertures 10, 12.

Chaque couche est gravée et, comme illustré sur les figures 5 et 1B, une portion 60, 62 de la couche supérieure 6 demeure au-dessus de chaque cavité 10', 12' gravée dans la couche 4 (voir également la structure détaillée de la figure 1B). Cette portion va permettre, comme déjà expliqué ci-dessus en liaison avec la figue 1B, de former une zone 11, 11' sur laquelle aucun dépôt n'aura lieu ultérieurement. Autrement dit, un dépôt aura lieu au fond de la cavité, sur la surface supérieure de la couche 6, partiellement sur les flancs de la cavité 10', mais pas sur certaines portions latérales de ces cavités et pas sur les surfaces inférieures 11, 11' des surplombs 60, 62. C'est par ces zones ne comportant pas de dépôt qu'une attaque en vue d'éliminer le masque (les couches 4, 6) pourra ensuite avoir lieu efficacement.

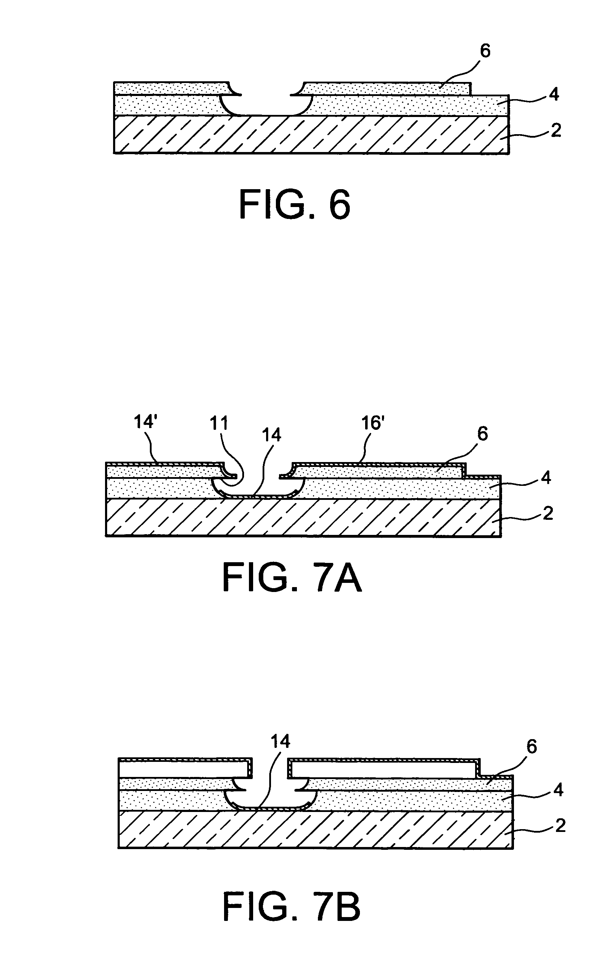

Puis, il y a retrait de la pâte polymère ou de la résine 8 (figure 6) _{:} pour ce retrait on peut par exemple utiliser un mélange eau/éthanol.

En variante, on peut conserver cette pâte polymère 8 si cela est compatible avec les futures étapes ; en effet la pâte polymère 8 est stable jusqu'à 150-200°C, et, lorsque le dépôt 14, 16 ne s'effectue pas sous vide il n'y a pas de risque de dégazage. Si la pâte polymère 8 est conservée la structure reste, pour les étapes suivantes, celle de la figure 4.

Les étapes précédentes ont permis de réaliser un masque de dépôt. On procède donc ensuite (figures 7A et 7B) au dépôt de la couche 14 à localiser : la présence du profil de gravure obtenu par les étapes précédentes (le profil avec le surplomb 60, 62) permet l'obtention d'un dépôt non continu : les parois des cavités réalisées dans le bicouche 4, 6 ne sont pas totalement recouvertes par le nouveau matériau 14 déposé. Dans les deux cas, que la pâte 8 ait été éliminée, ou pas, un dépôt 140, 160 du matériau à déposer a également lieu sur les surfaces supérieures du bicouche ou de la couche de pâte 8. Par contre, comme expliqué ci-dessus, le profil obtenu dans le bicouche, et notamment le surplomb, permet à une partie de la cavité de ne pas être recouverte de matériau à déposer. Est ainsi créée une discontinuité dans le dépôt de ce matériau, discontinuité qui va permettre d'attaquer aisément le bicouche en vue de son élimination.

A titre d'exemple, on peut déposer, en tant que matériau 14, des matériaux diélectriques déposés par CVD thermique ou CVD assistée plasma ou centrifugation (a-SiN:H, ou a-SiOx, ou a-SiC:H, ou a-SiON:H, ou a-SiOC:H...) ; on peut aussi déposer des métaux ou des alliages de métaux par pulvérisation cathodique ou évaporation (par exemple : Al, ou ITO, ou Au ou autres). Ce matériau 14 est compatible avec une gravure ultérieure de la couche 4 et n'est pas éliminé au cours de cette gravure.

L'épaisseur de cette couche 14 est choisie de préférence pour faciliter la délamination du masque, c'est-à-dire son élimination. L'épaisseur maximale que l'on peut déposer, sans empêcher la délamination, varie selon la nature du matériau 14 et l'épaisseur du bicouche 4, 6 ou du masque.

Par exemple, une couche 14 de 5 nm de a-Si:H est correctement localisée en attaquant par une solution de HF 5 % à 20°C un bicouche 4, 6 de 200 nm de SiO₂., chaque couche du bicouche présentant une stoechiométrie différente (conduisant à des vitesses de gravure différentes pour les deux couches, plus rapides pour la couche 4) L'emploi d'un bicouche 4, 6 facilite la délamination (par la création du surplomb, comme expliqué ci-dessus) et autorise donc une épaisseur plus importante de a-Si:H à partir du masque de 200 nm d'épaisseur. La délamination est moins satisfaisante avec l'empilement suivant : 50 nm de a-Si:H (= couche 14) sur 100 nm de SiO₂ (couches 4 et 6).

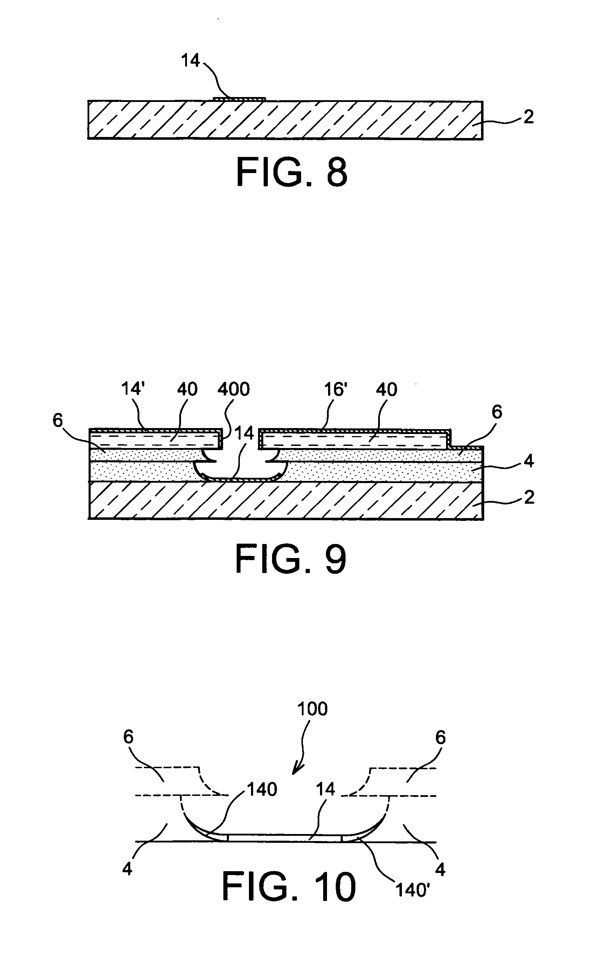

Après formation du dépôt discontinu, il y a ensuite (figure 8) délamination ou décollement du bicouche ou de l'empilement pâte polymère/bicouche, par attaque chimique (par exemple attaque au HF dans le cas d'une sous-couche d'oxyde de silicium ; attaque au H₂O₂ dans le cas du germanium, ou au H₃PO₄ dans le cas du nitrure SiN) : la non continuité de la couche 14 déposée permet l'attaque chimique du bicouche 4, 6. En particulier l'interface couche 6/couche 4, au voisinage de laquelle aucune matière n'a été déposée lors du dépôt 150, va permettre de former un canal d'introduction du liquide d'attaque chimique.

On donne ci-dessous un exemple de réalisation pour un bicouche SiN/SiO_{2 :}
- le bicouche comporte une couche de SiN, d'épaisseur 20 nm, déposé par PECVD à 180°C (couche 6) et une couche de SiO₂, d'épaisseur 500 nm, déposé par PECVD à 180°C (couche 4),
- la couche 14 à localiser est en silicium amorphe (a-Si:H), de 10 nm d'épaisseur, et elle est déposée par PECVD,
- la solution utilisée pour graver le bicouche 4,5 est du HF (à 5 %) à 20°C.

En variante, en particulier dans le cas du dépôt d'une couche 14 de silicium amorphe, il peut être intéressant d'effectuer un traitement O₃. Ce traitement permet d'oxyder en surface cette couche 14 de a-Si:H mais aussi les éventuelles parties latérales 140, 140' de cette couche (voir figure 10).

La surface du matériau amorphe ainsi oxydé sera gravée par le HF lors de l'étape d'élimination du masque 4, 6. On obtient ainsi une surface de meilleure qualité, avec moins de défauts et n'ayant pas été exposée au traitement de retrait du polymère 8.

Par ailleurs, dans le cas d'un dépôt 14 de silicium amorphe, la réalisation d'une oxydation permet d'éliminer les éventuels résidus latéraux, de part et d'autre de chaque dépôt localisé : ce problème est illustré sur la figure 10, où l'on reconnaît le dépôt 14, et les parois de la couche 4, éliminée par gravure chimique. On voit sur cette figure que des résidus latéraux 140' de silicium déposés subsistent, même après élimination de la couche 4. Si une oxydation du silicium a eu lieu, pendant une durée suffisante pour oxyder complètement ou presque complètement les portions latérales 14', 16', mais insuffisante pour oxyder les dépôts 14, 16 réalisées au fond des cavités 100, 120 autrement que de manière superficielle, lesdites portions latérales pourront être éliminées avec les couches 4, 6 ou 9 (cas d'une seule couche, figure 9).

L'invention a été expliquée à l'aide d'exemples dans lesquels le masque comportait deux couches. Il est également possible d'utiliser une troisième couche, de préférence présentant une sélectivité totale pour les gravures chimiques utilisées pour les couches sous-jacentes ; autrement dit, cette troisième couche n'est de préférence pas attaquée latéralement lors de ces étapes de gravures chimiques. La figure 9 représente la même étape que celle illustrée en figure 7B (des références numériques identiques désignant des éléments identiques ou similaires), mais avec une troisième couche désignée par la référence 40. On voit sur cette figure que les deux couches 4, 6 ont été gravés, mais que la couche 40 est intacte, sauf pour les ouvertures 400, 402, qui reproduisent celles réalisées préalablement dans la couche de polymère ou de résine (non représentée sur la figure). Toutes les considérations ci-dessus, relatives à la gravure des deux couches sous-jacentes 4, 6, sur la nature des divers matériaux composant la ou les couches formant le masque, ainsi que sur la nature du matériau à déposer, restent valables. En particulier, le dépôt réalisé sera discontinu, et cette discontinuité permettra ensuite d'éliminer le masque.

## Revendications

1. Procédé de réalisation d'un dépôt (14) non continu d'un premier matériau sur un substrat (2), comportant :
a) la formation d'un masque sur ce substrat (2), par formation d'au moins deux couches (4, 6) de masque, une couche supérieure (6) et une couche inférieure (4), la plus proche du substrat (2), et la gravure d'au moins une cavité (100, 10, 10', 12, 12') dans ces couches (4, 6), ladite au moins une cavité (100, 10, 10', 12, 12', ayant un profil tel qu' un dépôt (14), réalisé sur le substrat (2), à travers ladite au moins une cavité (100, 10, 10', 12, 12' du masque, présente au moins une discontinuité sur ledit profil de ladite au moins une cavité (100, 10, 10', 12, 12',
b) le dépôt (14) du premier matériau (14, 16, 14', 16'), en silicium amorphe, sur le substrat (2), à travers ladite au moins une cavité (100, 10, 10', 12, 12' du masque, ce dépôt (14) comportant au moins une discontinuité sur le profil de ladite au moins une cavité (100, 10, 10', 12, 12', puis l'oxydation du silicium amorphe,
c) l'élimination du masque.

2. Procédé selon la revendication 1, la formation ladite au moins une cavité (100, 10, 10', 12, 12' comportant un dépôt localisé préalable, sur lesdites deux couches (4, 6) de masque, d'une couche d'une pâte polymère ou de résine (8), délimitant, entre les zones de dépôt, des zones de gravure desdites deux couches (4, 6) de masque.

3. Procédé selon la revendication 2, dans lequel la couche de polymère ou de résine (8) est éliminée avant l'étape b), ou n'est pas éliminée avant l'étape b).

4. Procédé selon l'une des revendications 1 à 3, la gravure au moins de la couche (4) la plus proche du substrat étant une gravure non anisotrope.

5. Procédé selon l'une des revendications 1 à 4, les deux couches (4, 6) superposées présentant des vitesses de gravure différentes l'une de l'autre.

6. Procédé selon l'une des revendications 1 à 5, les deux couches (4, 6) superposées ayant une épaisseur totale comprise entre 100 nm et 2000 nm.

7. Procédé selon l'une des revendications 1 à 6, la couche supérieure (6) étant plus résistante à une chimie de gravure que la couche inférieure (4).

8. Procédé selon l'une des revendications 1 à 7, la couche supérieure (6) étant gravée par une chimie de gravure différente de celle utilisée pour graver ensuite la couche inférieure (4).

9. Procédé selon l'une des revendications 1 à 8, les deux couches (4, 6) superposées comportant :
- une couche (6) de nitrure de silicium SiN sur une couche (4) d'oxyde de silicium,
- ou une couche (6) d'oxyde de silicium SiOₓ sur une couche (4) également en oxyde de silicium SiO_{y} (avec x ≠ y),
- ou une couche (6) d'oxyde de silicium sur une couche (4) de FSG,
- ou une couche (6) de SiN sur une couche (4) de FSG,
- ou une couche (6) de nitrure de silicium SiN sur une couche (4) de FSG,
- ou une couche (6) de nitrure de silicium SiN sur une couche (4) de SOG,
- ou une couche (6) de SOG (SOG1) sur une couche (4) de SOG (SOG2),
- ou une couche (6) d'un diélectrique organique BCB sur une couche (4) d'oxyde de silicium.

10. Procédé selon l'une des revendications 1 à 9, la formation du masque comportant la formation d'une couche supplémentaire (40) sur les deux couches (4, 6) de masque, cette couche supplémentaire pouvant n'être pas attaquée latéralement lors de l'étape de gravure de la cavité.

11. Procédé selon l'une des revendications 1 à 10, la gravure de la couche inférieure (4), et éventuellement de la couche supérieure (6), étant de type chimique au HF.

12. Procédé selon l'une des revendications 1 à 11, l'oxydation du silicium amorphe ayant lieu pendant une durée permettant d'oxyder complètement ou presque complètement des parties latérales (140, 140') du silicium amorphe déposé au fond des cavités, sans oxyder les dépôts (14, 16) de silicium amorphe réalisés au fond de ladite au moins une cavité (100, 10, 10', 12, 12') autrement que de manière superficielle.

13. Procédé selon l'une des revendications 1 à 12, l'étape b) de dépôt étant effectuée par PECVD, ou par évaporation ou pulvérisation cathodique.

14. Procédé selon l'une des revendications 1 à 13, la gravure de l'étape a) permettant d'obtenir des flancs arrondis (100', 101') au moins dans la couche inférieure (4) et/ou une gravure de la couche supérieure (6) de manière à former un surplomb (60, 62) au-dessus de la zone gravée dans la couche inférieure.

15. Procédé selon l'une des revendications 1 à 14, l'étape c) étant réalisée par gravure chimique des couches (4, 6) formant masque, par les zones de premier matériau formant discontinuités.

## Claims

1. Method of depositing a non-continuous coating (14) of a first material on a substrate (2), comprising:
a) the formation of a mask on this substrate (2), by forming at least two mask layers (4, 6), an upper layer (6) and a lower layer (4), the nearest to the substrate (2), and etching of at least one cavity (100, 10, 10', 12, 12') in these layers, said at least one cavity (100, 10, 10', 12, 12') having a profile such that a deposit (14), deposited on the substrate (2), through said at least one cavity (100, 10, 10', 12, 12') of the mask, has at least one discontinuity over said profile of said at least one cavity (100, 10, 10', 12, 12'),
b) the deposition (14) of the first material (14, 16, 14', 16'), made of amorphous silicon, on the substrate (2), through said at least one cavity (100, 10, 10', 12, 12') of the mask, this coating (14) thus deposited having at least one discontinuity over the profile of said at least one cavity (100, 10, 10', 12, 12'), then an oxidation of the amorphous silicon, and c) the removal of the mask.

2. Method according to claim 1, the formation of said at least one cavity (100, 10, 10', 12, 12') comprising a prior localised coating, on said two mask layers (4, 6), of a polymer paste or resin layer (8), delimiting, between the coating zones, etching zones of said two mask layers (4, 6).

3. Method according to claim 2, in which the polymer or resin layer (8) is removed before step b), or is not removed before step b).

4. Method according to one of claims 1 to 3, the etching at least of the layer (4) the nearest to the substrate being a non-anisotropic etching.

5. Method according to one of claims 1 to 4, the two superimposed layers (4, 6) having etching rates different to each other.

6. Method according to one of claims 1 to 5, the two superimposed layers (4, 6) having a total thickness ranging between 100 nm and 2000 nm.

7. Method according to one of claims 1 to 6, the upper layer (6) being more resistant to an etching chemistry than the lower layer (4).

8. Method according to one of claims 1 to 7, the upper layer (6) being etched by an etching chemistry different to that then used to etch the lower layer (4).

9. Method according to one of claims 1 to 8, the two superimposed layers (4, 6) comprising:
- a layer (6) of silicon nitride SiN over a layer (4) of silicon oxide,
- or a layer (6) of silicon oxide SiOₓ over a layer (4) also of silicon oxide SiO_{y} (where x ≠ y),
- or a layer (6) of silicon oxide over a layer (4) of FSG,
- or a layer (6) of SiN over a layer (4) of FSG,
- or a layer (6) of silicon nitride SiN over a layer (4) of FSG,
- or a layer (6) of silicon nitride SiN over a layer (4) of SOG,
- or a layer (6) of SOG (SOG1) over a layer (4) of SOG (SOG2),
- or a layer (6) of an organic dielectric BCB over a layer (4) of silicon oxide.

10. Method according to one of claims 1 to 9, the formation of the mask comprising the formation of an additional layer (40) over the two mask layers (4, 6), said additional layer possibly not being attacked laterally during the step of etching the cavity.

11. Method according to one of claims 1 to 10, the etching of the lower layer (4), and if necessary the upper layer (6), being of HF chemical type.

12. Method according to one of claims 1 to 11, the oxidation of the amorphous silicon taking place for a time that makes it possible to oxidise completely or almost completely lateral portions (140, 140') of the amorphous silicon deposited at the bottom of the cavities, without oxidising the deposits (14, 16) of amorphous silicon deposited at the bottom of said at least one cavity (100, 10, 10', 12, 12') other than in a superficial manner.

13. Method according to one of claims 1 to 12, coating step b) being carried out by PECVD, or by evaporation or cathodic sputtering.

14. Method according to one of claims 1 to 13, the etching of step a) making it possible to obtain rounded sides (100', 101') at least in the lower layer (4) and/or an etching of the upper layer (6) so as to form an overhang (60, 62) above the zone etched in the lower layer.

15. Method according to one of claims 1 to 14, step c) being carried out by chemical etching of the mask forming layers (4, 6), through zones of first material forming discontinuities.

## Patentansprüche

1. Verfahren zum Aufbringen bzw. Realisieren einer nichtkontinuierlichen Beschichtung (14) aus einem ersten Material auf ein Substrat (2), umfassend:
a) die Bildung einer Maske auf dem Substrat (2) durch Bildung von mindestens zwei Maskenschichten (4, 6), einer oberen Schicht (6) und einer unteren Schicht (4), die dem Substrat (2) am nächsten ist, und die Ätzung mindestens einer Vertiefung (100, 10, 10', 12, 12') in diese Schichten (4, 6), wobei die mindestens eine Vertiefung (100, 10, 10', 12, 12') ein solches Profil aufweist, dass eine Beschichtung (14), die auf dem Substrat (2) durch die mindestens eine Vertiefung (100, 10, 10', 12, 12') der Maske erfolgt, mindestens eine Diskontinuität über das Profil der mindestens einen Vertiefung (100, 10, 10', 12, 12') darstellt,
b) Beschichtung (14) aus dem ersten Material (14, 16, 14', 16'), aus amorphem Slicium, auf dem Substrat (2), durch die mindestens eine Vertiefung (100, 10, 10', 12, 12') der Maske, wobei diese Beschichtung (14) mindestens eine Diskontinuität über das Profil der mindestens einen Vertiefung (100, 10, 10', 12, 12') aufweist, dann die Oxidation des amorphen Siliciums,
c) Entfernung der Maske.

2. Verfahren nach Anspruch 1, wobei die Bildung der mindestens einen Vertiefung (100, 10, 10', 12, 12') eine vorher lokalisierte Beschichtung umfasst, über den beiden Schichten (4, 6) der Maske, aus einer abgrenzenden Beschichtung aus einer Polymerpaste oder einem Harz (8), zwischen den Beschichtungszonen, den Ätzzonen der beiden Schichten (4, 6) der Maske.

3. Verfahren nach Anspruch 2, worin die Schicht aus Polymer oder Harz (8) vor Schritt b) entfernt wird oder vor Schritt b) nicht entfernt wird.

4. Verfahren nach einem der Ansprüche 1 bis 3, worin die Ätzung von mindestens der Schicht (4), die am nächsten zum Substrat ist, eine nichtanisotrope Ätzung ist.

5. Verfahren nach einem der Ansprüche 1 bis 4, worin die beiden überlagerten Schichten (4, 6) voneinander verschiedene Ätzgeschwindigkeiten bereitstellen.

6. Verfahren nach einem der Ansprüche 1 bis 5, worin die beiden überlagernden Schichten (4, 6) eine Gesamtdicke aufweisen, umfassend 100 nm und 2000 nm.

7. Verfahren nach einem der Ansprüche 1 bis 6 worin die obere Schicht (6) gegenüber Ätzchemie beständiger ist als die untere Schicht (4).

8. Verfahren nach einem der Ansprüche 1 bis 7, worin die obere Schicht (6) durch eine Ätzchemie geätzt wird, die verschieden von derjenigen ist, die anschließend zum Ätzen der unteren Schicht (4) verwendet wird.

9. Verfahren nach einem der Ansprüche 1 bis 8, worin die beiden überlagernde Schichten (4, 6) umfassen:
- eine Schicht (6) aus Sicliciumnitrit SiN über einer Schicht (4) aus Siliciumoxid,
- oder eine Schicht (6) aus Siliziumoxid (SiOₓ) über einer Schicht (4), die ebenfalls aus Siliciumoxid (SiO_{y}) (mit x≠y) ist,
- oder eine Schicht (6) aus Siliciumoxid über einer Schicht (4) aus FSG,
- oder eine Schicht (6) aus SiN über einer Schicht (4) aus FSG,
- oder eine Schicht (6) aus Siliciumnitrit SiN über einer Schicht (4) aus FSG,
- oder eine Schicht (6) aus Siliciumnitrit über einer Schicht (4) aus SOG,
- oder eine Schicht (6) aus SOG (SOG1) über einer Schicht (4) aus SOG (SOG2),
- oder eine Schicht (6) aus dielektrischen organischen BCB über einer Schicht (4) aus Sliciumoxid.

10. Verfahren nach einem der Ansprüche 1 bis 9, wobei die Bildung der Maske die Bildung einer zusätzlichen Schicht (40) auf den beiden Schichten (4, 6) der Maske umfasst, wobei diese zusätzliche Schicht nicht lateral angegriffen werden kann während des Ätzschritts der Vertiefung.

11. Verfahren nach einem der Ansprüche 1 bis 10, worin die Ätzung der unteren Schicht (4) und gegebenenfalls der oberen Schicht (6) vom HF-Chemie-Typ ist.

12. Verfahren nach einem der Ansprüche 1 bis 11, worin die Oxidation von amorphem Silizium für eine Dauer stattfindet, die es erlaubt die lateralen Teile (140, 140') von amorphem Silicium, das am Boden der Vertiefungen abgelagert ist, vollständig oder nahezu vollständig zu oxidieren, ohne die Schichten (14, 16) aus amorphem Silicium, die auf dem Boden der mindestens einen Vertiefung (100, 10, 10', 12, 12') realisiert sind, zu oxidieren, außer oberfächlich.

13. Verfahren nach einem der Ansprüche 1 bis 12, worin Schritt b) der Beschichtung bewirkt wird durch PECVD oder durch Verdampfung oder kathodische Pulverisierung.

14. Verfahren nach einem der Ansprüche 1 bis 13, worin das Ätzen des Schritts a) es erlaubt abgerundete Flanken (100', 101') zumindest in der unteren Vertiefung (4) und/oder eine Ätzung der oberen Schicht (6) zu erhalten, um eine Auskragung (60, 62) über der geätzte Zone in der unteren Schicht zu bilden.

15. Verfahren nach einem der Ansprüche 1 bis 14, worin Schritt c) realisiert wird durch chemisches Ätzen der Schichten (4, 6), die eine Maske bilden, durch die Zonen des ersten Materials, wodurch Diskontinuitäten gebildet werden.
